# EUROPEAN PATENT SPECIFICATION

(11) **EP 3 309 569 B1**
(45) Date of publication and mention of the grant of the patent: **19.06.2019**
(21) Application number: 17195871.3
(22) Date of filing: 11.10.2017
(51) Int. Cl.: G01R 33/00

(54) **HALL SENSOR ASSEMBLY AND ASSOCIATED WRAPPING MACHINE**
HALLSENSORANORDNUNG UND ZUGEHÖRIGE VERPACKUNGSMASCHINE
ENSEMBLE DE CAPTEUR HALL ET MACHINE D'EMBALLAGE ASSOCIÉE

(30) Priority: 14.10.2016 US 201662408115 P; 07.04.2017 US 201715482002
(43) Date of publication of application: 18.04.2018
(73) Proprietor: Illinois Tool Works, Inc., Glenview, Illinois 60025 (US)
(72) Inventor: BYCZKOWSKI, Leszek P., Glenview, Illinois 60025 (US)
(74) Representative: Trinks, Ole

(56) References cited:
- EP-A1- 1 053 940
- CN-A- 104 848 983
- DE-A1-102014 205 307
- US-A- 5 929 629
- US-A1- 2002 055 803
- US-A1- 2010 176 695

## Description

### TECHNICAL FIELD

This application relates generally to a Hall effect sensor assembly and, more specifically, to a Hall effect sensor assembly useful in a food product wrapping machine.

### BACKGROUND

Packaging machines are frequently used to automatically wrap film about product, such as trayed food items. The packaging machines typically include a film gripper that grips and pulls the film from a roll of film, side clamps that grip the film, and folders that fold the film underneath the product. Once the film is folded under the package, the package is delivered to a sealer belt to heat the underside of the package for film sealing. Timing of the movement of the various components of the machine is important and can vary between package size and type being wrapped. In some situations it is important if one component is not moved until another component is in a specific position. Hall sensors can be used to detect component position when the component incorporates a magnet.

It would be desirable to provide a Hall sensor assembly that is effective for component detection, sealed for protection, easily mountable and/or relatively inexpensive to manufacture, US2010/176695, US5929629, CN104848983, DE102014205307, EP1053940 and US2002/055803 disclose Hall sensor assemblies.

The invention is defined by claim 1.

### SUMMARY

In one aspect, a Hall effect sensor assembly includes a tubular sleeve having an external surface portion that is threaded to facilitate mounting. A circuit board assembly has a Hall effect sensor mounted thereon. The circuit board assembly is disposed within the tubular sleeve and includes a first portion and a second portion. The first portion extends substantially lengthwise along the tubular sleeve, and the second portion extends laterally from the first portion. The Hall effect sensor is mounted on the second portion such that a sensing face of the Hall effect sensor faces one end of the tubular sleeve.

In another aspect, a Hall effect sensor assembly includes an elongated tubular housing with an internal circuit board assembly. The circuit board assembly includes a Hall effect sensor mounted thereon. The circuit board assembly includes a first portion and a second portion. The first portion extends substantially lengthwise along the elongated tubular housing, and the second portion extends laterally from the first portion. The Hall effect sensor is mounted on the second portion such that a sensing face of the Hall effect sensor faces one end of the elongated tubular housing.

In a further aspect, a Hall effect sensor assembly includes a tubular sleeve and a flexible circuit board with a Hall effect sensor thereon and disposed within the tubular sleeve.

The details of one or more embodiments are set forth in the accompanying drawings and the description below. Other features, objects, and advantages will be apparent from the description and drawings, and from the claims.

### BRIEF DESCRIPTION OF THE DRAWINGS

Fig. 1 shows a schematic plan view of a circuit board assembly;
Figs. 2 and 3 show views of the circuit board assembly after bending;
Figs. 4 and 5 show the circuit board assembly loaded into a tubular sleeve;
Fig. 6 shows a fully assembled sensor assembly;
Figs. 7 and 8 show a tab contact at the end of one wire;
Figs. 9-11 show views of a tab housing;
Figs. 12 and 13 show perspective and side elevation views of one embodiment of a wrapping machine;
Fig. 14 shows a side schematic view of the wrapping machine showing trayed item movement through the machine; and
Fig. 15 shows a partial perspective of an infeed station of the wrapping machine with a Hall effect sensor assembly mounted for detecting conveyor lug movement.

### DETAILED DESCRIPTION

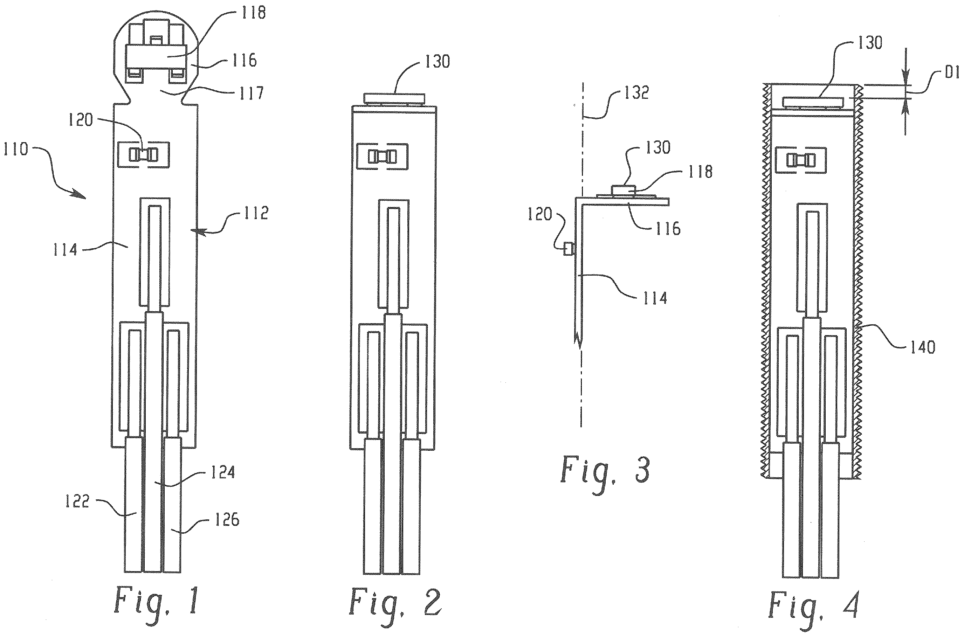

Referring to Fig. 1, an exemplary circuit board assembly 110 is shown, where a circuit board 112 of a flexible type includes a main body portion 114 and a head portion 116 interconnected by a narrower intermediate portion 117. A Hall effect sensor 118 is connected to mount pads on the head portion 116, and a capacitor 120 is connected to mount tabs on the body portion 114. Power, ground and signal wires 122, 124 and 126 are connected to pads on the body portion 114 as well. Fig. 1 shows the circuit board 112 before any bending takes place.

Figs. 2 and 3 show views in which the head portion 116 of the circuit board 112 is bent at about ninety degrees relative to the body portion 114 in order to position a sensing face 130 of the Hall effect sensor substantially perpendicular to the elongate axis 132 of the circuit board 112. The narrower neck or intermediate part 117 (Fig. 1) between the body and head portions facilitates the bending operation. The flexible circuit board is of material and configuration such that the bending operation does not adversely affect the electrical trace paths between the head portion 116 and the body portion 114.

Per Fig. 4, the bent circuit board assembly is positioned within a tubular sleeve member 140 with the sensing face 130 of the Hall effect sensor positioned proximate to but spaced slightly from one end of the tubular sleeve member (e.g., per distance DP. The tubular sleeve member may be a rigid member that will help to provide a fixed position of the circuit board assembly within the tube. By way of example, the sensing face 130 may be positioned a distance D1 that is between 5 thousandths and 100 thousandths of an inch from the end face of the tubular sleeve 140, though other variations are possible.

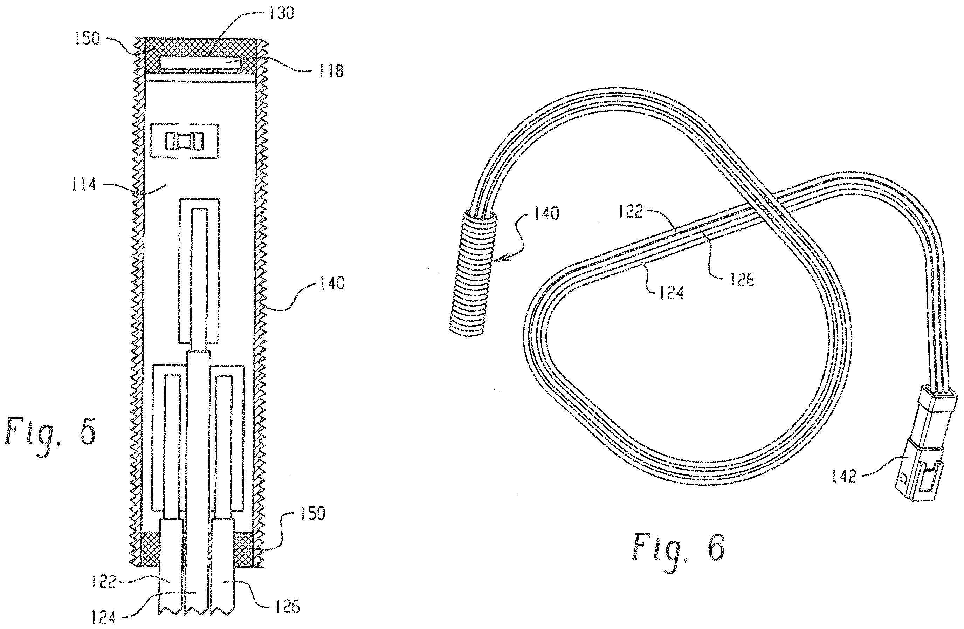

Per Fig. 5, once the circuit board is positioned within the tubular sleeve 140, a potting material 150 can be added to the interior of the tubular sleeve. Once hardened, the potting material 150 fixes the position of the circuit board assembly and the Hall effect sensor within the tubular sleeve and also seals the circuit board assembly and Hall effect sensor from outside elements (e.g., moisture). A suitable electrical grade epoxy may be used for the potting material and should be located at least at the end portions of the tubular sleeve. The potting material 150 may extend from the Hall effect sensor end of the tubular sleeve 140 and along the entire length of interior of the tubular sleeve to the other end so as to encase at least a portion of each of the wires as shown.

To assemble the parts, the tubular sleeve 140 may be placed vertically in a fixture, the pre-bent circuit board 112 (with components already mounted thereon) is then moved downward into the tubular sleeve to position the sensing face 130 proximate the lower end of the tubular sleeve, and then liquid epoxy poured into the tubular sleeve. The epoxy surrounds the circuit board and moves below the Hall sensing face 130 to fill the gap between the Hall sensing face 130 and the end face of the tubular sleeve. Once the epoxy cures, it hardens and the sensor assembly can be removed from the fixture. The cured epoxy fixes the position of the circuit board and Hall effect sensor, and also seals the board and sensor from the environment. The hardened epoxy also provides a strain relief function for the wiring.

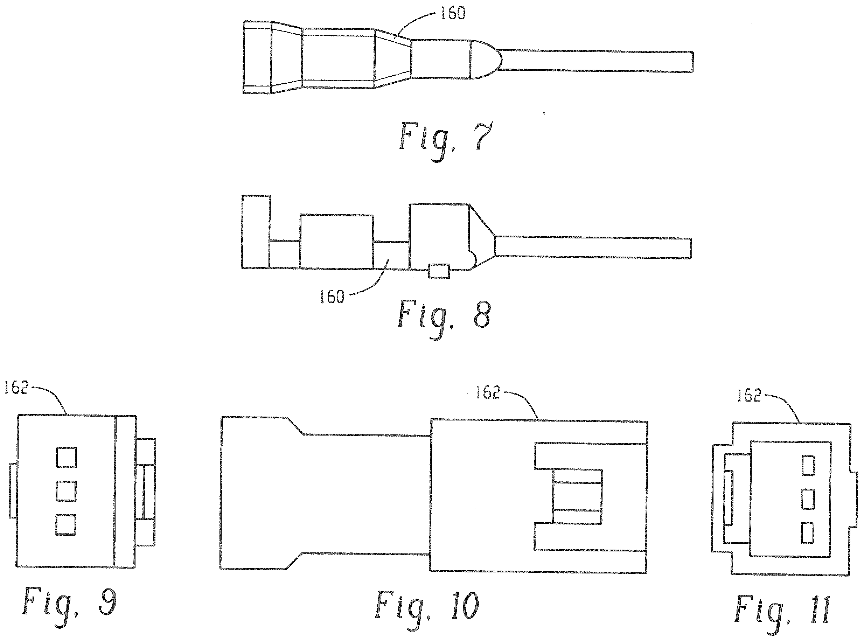

As seen in Figs. 5 and 6, the tubular sleeve may be an externally threaded metal barrel to facilitate mounting of the sensor assembly (e.g., by threading the sensor assembly into a tapped hole or by using one or more nuts to secure the sensor assembly to a metal plate with a through hole). The wires 122, 124, 126 lead to a connector 142 to facilitate use, where the connector 142 may be formed by a tab contact positioned at the end of each wire, with all tab contacts located within a single tab housing. Figs. 7 and 8 show views of an exemplary tab contact 160 and Figs. 9-11 show exemplary views of a tab housing 162.

The subject Hall effect sensor assembly is water resistant and protected against metal to metal contact. In one use, the Hall effect sensor assembly may be mounted in a wrapping machine to detect positioning of a movable component carrying a magnet.

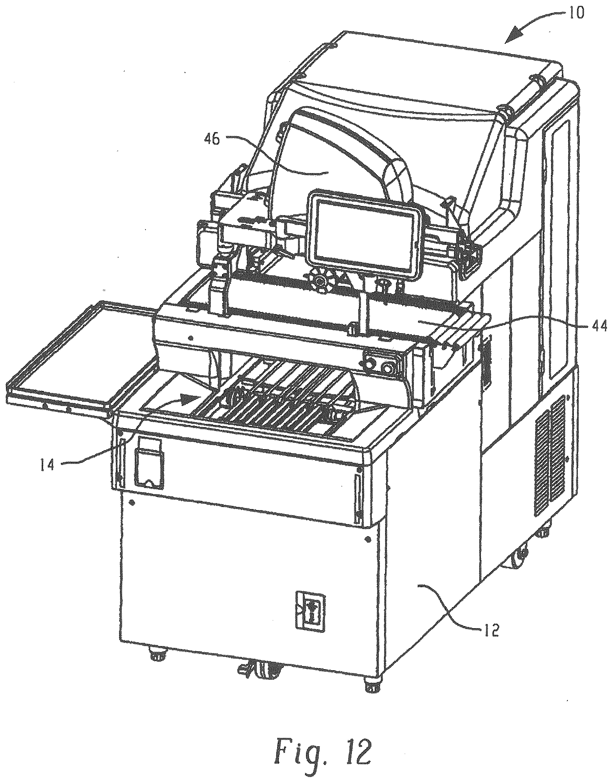

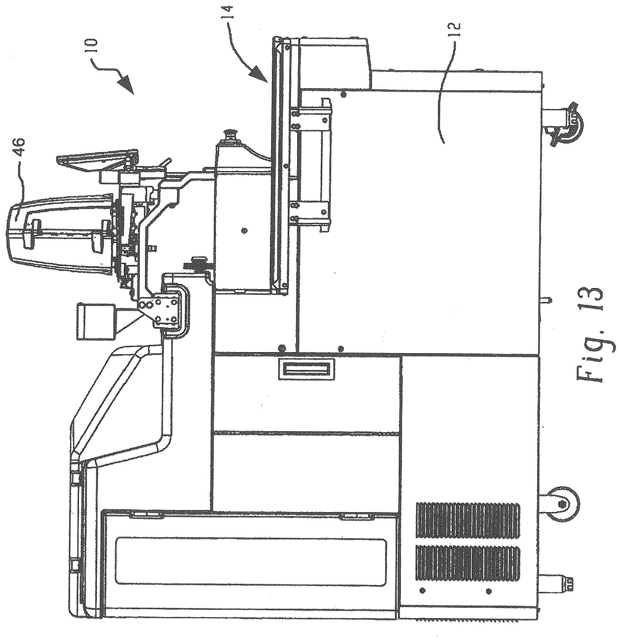

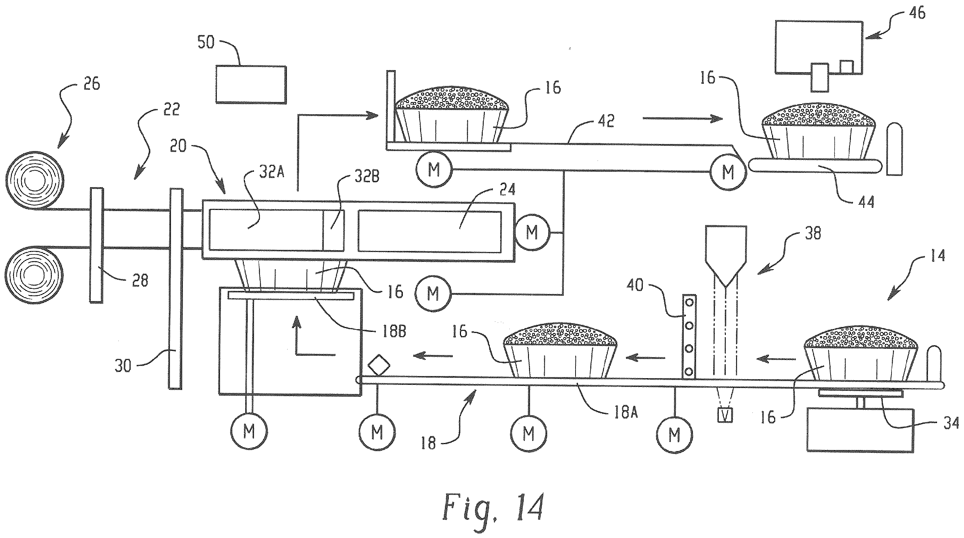

In this regard, reference is made to Figs. 12-14, in which a food product wrapping machine 10 includes an inner frame and outer housing 12. An inlet area 14 provides a location at which products to be wrapped (e.g., food items 16, such as meats in trays) are input to the machine for wrapping in plastic film. The inlet area 14 is part of a conveying system 18 that carries packages into the machine (right to left in Figs. 13 and 14) and then up into a wrap station 20 at which the food products are wrapped. Here the conveying system includes one or more horizontal conveyors 18A that feed from the front of the machine back to an elevator mechanism 18B. A film dispensing system 22 is provided for drawing out film over food products at the wrap station 20 (e.g., under control of a film gripper 24 that moves left to right in Fig. 14 in order to draw off film from one or more film rolls 26). Where more than one film roll is provided (e.g., of differing film widths), an actuatable film selector 28 provides the ability to select the desired film for a given wrap operation (e.g., depending upon size of the food product). An actuatable film knife 30 is provided to cut the film at the appropriate time to enable the wrap operation to be completed. The wrap station may include side clamps 32A, 32B to grip the lateral sides of the film, as well as side underfolders and a rear underfolder (not shown).

A weighing mechanism 34 is located at the inlet area for weighing the food product as it is placed into the machine. Once a stable weight is determined, the food product 16 is moved laterally into the machine through a light curtain imaging system 38 and past a height sensor array 40 for determining size of the food product and location of the food product on the conveyor. Part of the horizontal conveying system 18A may be shifted (e.g., into or out of the page in Fig. 14) as necessary to assure that the food product is properly centered when it is transferred onto the elevator mechanism 18B. After the food product is moved up into the wrap station 20 and wrapped, the wrapped food product is conveyed by a conveyor 42 back toward the front of the machine and deposited onto another horizontal conveyor 44, which here moves left or right (into or out of the page in Fig. 14). The conveyor 42 includes an associated sealer belt that heats the bottom of the wrapped food product to seal the film, and a label printing mechanism 46 prints and applies a pricing label to the wrapped food product. An exemplary controller 50 is shown for controlling machine operation. As used herein, the term controller is intended to broadly encompass any circuit (e.g., solid state, application specific integrated circuit (ASIC), an electronic circuit, a combinational logic circuit, a field programmable gate array (FPGA)), processor(s) (e.g., shared, dedicated, or group - including hardware or software that executes code), software, firmware and/or other components, or a combination of some or all of the above, that carries out the control functions of the machine or the control functions of any component thereof.

Various motors M are shown and are used primarily for movement of the conveyor components, gripper components and underfolders. However, a plurality of pneumatic components are also provided for control of components, where each pneumatic component is actuatable by delivery of pressurized air.

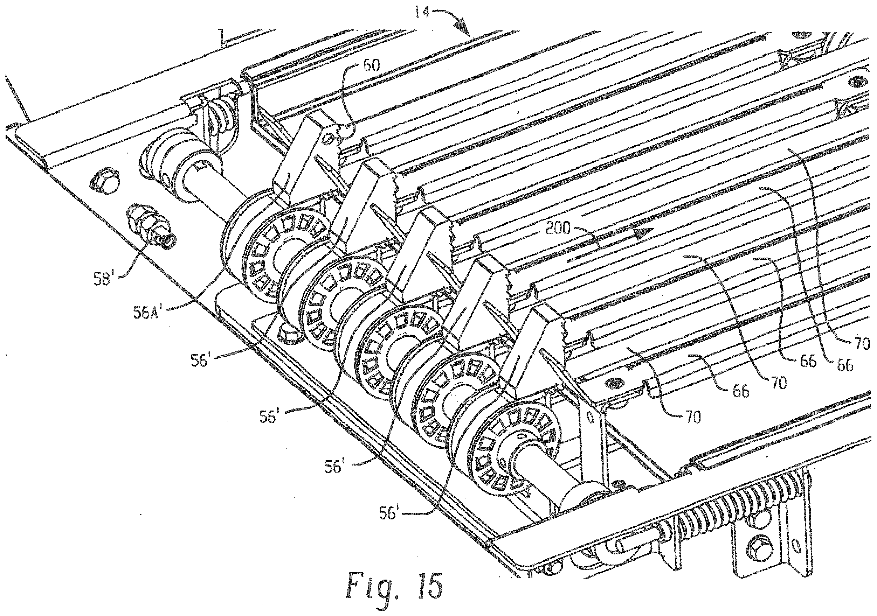

The Hall effect sensor assembly can be located in the machine to detect location of any of the moving components (e.g., conveyors, grippers, clamps, folders, knife etc.). By way of example, and as seen in Fig. 15, a partial perspective view of one embodiment of a machine infeed station 14 is shown, with a set of lugs 56' connected to respective belts 70 movable in direction 200, and with spaced apart trayed item support rails 66. Here, a Hall effect sensor 58' is mounted to an internal machine panel for detecting when an end lug 56A' of the lug set is located along the arcuate portion of a travel path of the lug. Here, the lug carries a magnet 60 in order to trigger the sensor 58' as the lug moves by the sensor. It is to be clearly understood that the above description is intended by way of illustration and example only, is not intended to be taken by way of limitation, and that other changes and modifications are possible.

## Claims

1. A Hall effect sensor assembly, comprising:
- a tubular sleeve (140); and
- a flexible circuit board (112) with a Hall effect sensor (118, 58') mounted thereon, the flexible circuit board (112) disposed within the tubular sleeve (140),
**characterized in that**
the flexible circuit board (112) includes a main body portion (114) and a head portion (116) connected by an intermediate portion (117), the main body portion (114) having an elongate axis that runs substantially parallel to an elongate axis of the tubular sleeve (140), the intermediate portion (117) forming a bend such that the main body portion (114) extends substantially perpendicularly relative to the elongate axis of the main body portion (114),
wherein the Hall effect sensor (118, 58') is mounted on the head portion (116) such that a sensing face (130) of the Hall effect sensor (118, 58') is oriented substantially perpendicular to the elongate axis of the tubular sleeve (140).

2. The Hall effect sensor assembly of claim 1,
wherein the tubular sleeve (140) is comprised of a rigid material (150).

3. The Hall effect sensor assembly of claim 1 or 2,
wherein the tubular sleeve (140) is formed as an externally threaded barrel.

4. The Hall effect sensor assembly of claim 1,
wherein the sensing face (130) is spaced from but proximate to one end face (130) of the tubular sleeve (140).

5. The Hall effect sensor assembly of claim 4,
wherein the sensing face (130) is spaced between 0,127 and 2,54 mm (5 thousandths and 100 thousandths of an inch) from the end face of the tubular sleeve (140).

6. The Hall effect sensor assembly of one of the preceding claims,
wherein the tubular sleeve (140) is at least partially filled with a potting material (150) that seals the flexible circuit board (112) and Hall effect sensor (118, 58') from external environment and fixes a position of the Hall effect sensor (118, 58') within the tubular sleeve (140).

7. The Hall effect sensor assembly of one of the preceding claims,
wherein the flexible circuit board (112) includes a first portion and a second portion, the first portion extending substantially lengthwise along the tubular sleeve (140), the second portion extending laterally from the first portion, wherein the Hall effect sensor (118, 58') is mounted on the second portion such that a sensing face (130) of the Hall effect sensor faces one end of the tubular sleeve (140).

8. The Hall effect sensor assembly of claim 7,
wherein the sensing face (130) is spaced from but proximate to the end of the tubular sleeve (140), the sensing face (130) is spaced between 0,127 and 2,54 mm (5 thousandths and 100 thousandths of an inch) from the end of the tubular sleeve (140).

9. A wrapping machine (10) for wrapping trayed food products and including at least one Hall effect sensor assembly according to one of the preceding claims, comprising:
- a wrap station (20) at which trayed food products are wrapped;
- a film dispensing system (22) for drawing out film at the wrap station;
- a conveying system (18) for moving trayed food products along a defined path from an input station to the wrap station; and
- at least one moving component (56A') carrying a magnet (60), wherein the Hall effect sensor assembly is located to detect movement of the component (56A') to a certain position.

## Patentansprüche

1. Hall-Effekt-Sensorbaugruppe, die Folgendes umfasst:
- eine röhrenförmige Hülle (140); und
- eine flexible Leiterplatte (112) mit einem Hall-Effekt-Sensor (118, 58') darauf montiert, wobei die flexible Leiterplatte (112) innerhalb der röhrenförmigen Hülle (140) angeordnet ist,
**dadurch gekennzeichnet, dass**
die flexible Leiterplatte (112) einen Hauptkörperteil (114) und einen Kopfteil (116), der mit einem Zwischenteil (117) verbunden ist, umfasst, wobei der Hauptkörperteil (114) eine Längsachse aufweist, die im Wesentlichen parallel zu einer Längsachse der röhrenförmigen Hülle (140) verläuft, wobei der Zwischenteil (117) eine solche Biegung bildet, dass sich der Hauptkörperteil (114) relativ zu der Längsachse des Hauptkörperteils (114) im Wesentlichen senkrecht erstreckt,
wobei der Hall-Effekt-Sensor (118, 58') so auf dem Kopfteil (116) montiert ist, dass eine Erfassungsfläche (130) des Hall-Effekt-Sensors (118, 58') im Wesentlichen senkrecht zu der Längsachse der röhrenförmigen Hülle (140) orientiert ist.

2. Hall-Effekt-Sensorbaugruppe nach Anspruch 1,
wobei die röhrenförmige Hülle (140) aus einem starren Material (150) besteht.

3. Hall-Effekt-Sensorbaugruppe nach Anspruch 1 oder 2,
wobei die röhrenförmige Hülle (140) als ein Zylinder mit Außengewinde gebildet ist.

4. Hall-Effekt-Sensorbaugruppe nach Anspruch 1,
wobei die Erfassungsfläche (130) von einer Endfläche (130) der röhrenförmigen Hülle (140) beabstandet, aber nahe dieser ist.

5. Hall-Effekt-Sensorbaugruppe nach Anspruch 4,
wobei die Erfassungsfläche (130) zwischen 0,127 und 2,54 mm (5 Tausendstel und 100 Tausendstel eines Zolls) von der Endfläche der röhrenförmigen Hülle (140) beabstandet ist.

6. Hall-Effekt-Sensorbaugruppe nach einem der vorhergehenden Ansprüche,
wobei die röhrenförmige Hülle (140) wenigstens teilweise mit einem Vergussmaterial (150) gefüllt ist, das die flexible Leiterplatte (112) und den Hall-Effekt-Sensor (118, 58') vor einer externen Umgebung versiegelt und eine Position des Hall-Effekt-Sensors (118, 58') innerhalb der röhrenförmigen Hülle (140) fixiert.

7. Hall-Effekt-Sensorbaugruppe nach einem der vorhergehenden Ansprüche,
wobei die flexible Leiterplatte (112) einen ersten Teil und einen zweiten Teil beinhaltet, wobei sich der erste Teil im Wesentlichen längs entlang der röhrenförmigen Hülle (140) erstreckt, wobei sich der zweite Teil lateral von dem ersten Teil erstreckt, wobei der Hall-Effekt-Sensor (118, 58') so auf dem zweiten Teil montiert ist, dass eine Erfassungsfläche (130) des Hall-Effekt-Sensors einem Ende der röhrenförmigen Hülle (140) zugewandt ist.

8. Hall-Effekt-Sensorbaugruppe nach Anspruch 7,
wobei die Erfassungsoberfläche (130) von dem Ende der röhrenförmigen Hülle (140) beabstandet, aber nahe dieser ist, wobei die Erfassungsfläche (130) zwischen 0,127 und 2,54 mm (5 Tausendstel und 100 Tausendstel eines Zolls) von dem Ende der röhrenförmigen Hülle (140) beabstandet ist.

9. Verpackungsmaschine (10) zum Einwickeln von in Schalen befindlichen Lebensmittelprodukten und einschließlich wenigstens einer Hall-Effekt-Sensorbaugruppe nach einem der vorhergehenden Ansprüche, die Folgendes umfasst:
- eine Einwickelstation (20), bei der in Schalen befindliche Lebensmittelprodukte eingewickelt werden;
- ein Folienabgabesystem (22) zum Herausziehen von Folie bei der Einwickelstation;
- ein Fördersystem (18) zum Bewegen von in Schalen befindlichen Lebensmittelprodukten entlang eines definierten Pfades von einer Eingangsstation zu der Einwicklungsstation; und
- wenigstens eine sich bewegende Komponente (56A'), die einen Magneten (60) trägt, wobei die Hall-Effekt-Sensorbaugruppe zum Detektieren einer Bewegung der Komponente (56A') zu einer gewissen Position lokalisiert ist.

## Revendications

1. Ensemble capteur à effet Hall comprenant :
- un manchon tubulaire (140) ; et
- une carte de circuit imprimé souple (112) sur laquelle est monté un capteur à effet Hall (118, 58'), la carte de circuit imprimé souple (112) étant disposée à l'intérieur du manchon tubulaire (140),
**caractérisé en ce que**
la carte de circuit imprimé souple (112) comprend une partie de corps principal (114) et une partie de tête (116) raccordée au moyen d'une partie intermédiaire (117), la partie de corps principal (114) ayant un axe allongé qui s'étend sensiblement de manière parallèle à un axe allongé du manchon tubulaire (140), la partie intermédiaire (117) formant un coude de telle sorte que la partie de corps principal (114) s'étende sensiblement de manière perpendiculaire par rapport à l'axe allongé de la partie de corps principal (114),
dans lequel le capteur à effet Hall (118, 58') est monté sur la partie de tête (116) de telle sorte qu'une face de détection (130) du capteur à effet Hall (118, 58') soit orientée sensiblement perpendiculairement à l'axe allongé du manchon tubulaire (140).

2. Ensemble capteur à effet Hall selon la revendication 1,
dans lequel le manchon tubulaire (140) est composé d'un matériau rigide (150).

3. Ensemble capteur à effet Hall selon la revendication 1 ou 2,
dans lequel le manchon tubulaire (140) se présente sous la forme d'un cylindre à filetage externe.

4. Ensemble capteur à effet Hall selon la revendication 1,
dans lequel la face de détection (130) est espacée d'une face d'extrémité (130), mais se trouve à proximité de cette dernière, du manchon tubulaire (140) .

5. Ensemble capteur à effet Hall selon la revendication 4,
dans lequel la face de détection (130) est espacée entre 0,127 et 2,54 mm (entre 5 millièmes et 100 millièmes d'un pouce) de la face d'extrémité du manchon tubulaire (140).

6. Ensemble capteur à effet Hall selon l'une des revendications précédentes,
dans lequel le manchon tubulaire (140) est au moins partiellement rempli d'un matériau de remplissage (150) qui isole la carte de circuit imprimé souple (112) et un capteur à effet Hall (118, 58') de l'environnement externe et fixe une position du capteur à effet Hall (118, 58') à l'intérieur du manchon tubulaire (140).

7. Ensemble capteur à effet Hall selon l'une des revendications précédentes,
dans lequel la carte de circuit imprimé souple (112) comprend une première partie et une seconde partie, la première partie s'étendant sensiblement dans le sens de la longueur le long du manchon tubulaire (140), la seconde partie s'étendant latéralement depuis la première partie, dans lequel le capteur à effet Hall (118, 58') est monté sur la seconde partie de telle sorte qu'une face de détection (130) du capteur à effet Hall soit orientée vers une extrémité du manchon tubulaire (140).

8. Ensemble capteur à effet Hall selon la revendication 7,
dans lequel la face de détection (130) est espacée de l'extrémité, mais se trouve à proximité de cette dernière, du manchon tubulaire (140), la face de détection (130) est espacée entre 0,127 et 2,54 mm (entre 5 millièmes et 100 millièmes d'un pouce) de l'extrémité du manchon tubulaire (140).

9. Machine d'emballage (10) pour emballer des produits alimentaires disposés sur des plateaux et comprenant au moins un ensemble capteur à effet Hall selon l'une des revendications précédentes, comprenant :
- une station d'emballage (20) au niveau de laquelle des produits alimentaires disposés sur des plateaux sont emballés ;
- un système de distribution de film (22) pour étirer un film au niveau de la station d'emballage ;
- un système de transport (18) pour déplacer des produits alimentaires disposés sur des plateaux le long d'un trajet défini depuis une station d'entrée jusqu'à la station d'emballage ; et
- au moins un composant mobile (56A') comportant un aimant (60), dans laquelle l'ensemble capteur à effet Hall est situé pour détecter un mouvement du composant (56A') jusqu'à une certaine position.
